# EUROPÄISCHE PATENTSCHRIFT

(11) **EP 2 652 809 B1**
(45) Veröffentlichungstag und Bekanntmachung des Hinweises auf die Patenterteilung: **01.07.2015**
(21) Anmeldenummer: 11793377.0
(22) Anmeldetag: 24.11.2011
(51) Int. Cl.: H01L 51/50, H01L 51/54

(54) **ORGANISCHES LICHTEMITTIERENDES BAUELEMENT UND VERWENDUNG EINES KUPFERKOMPLEXES IN EINER LADUNGSTRANSPORTSCHICHT**
ORGANIC LIGHT EMITTING DEVICE AND USE OF A COPPER COMPLEX IN A CHARGE TRANSFER LAYER
COMPOSANT ÉLECTROLUMINESCENT ORGANIQUE ET UTILISATION D'UN COMPLEXE DE CUIVRE DANS UNE COUCHE DE TRANSPORT DE CHARGE

(30) Priorität: 13.12.2010 DE 102010062877
(43) Veröffentlichungstag der Anmeldung: 23.10.2013
(73) Patentinhaber: OSRAM Opto Semiconductors GmbH, 93055 Regensburg (DE)
(72) Erfinder: KRISTUKAT, Christian, 1217 Buenos Aires, CABA (AR); LANG, Erwin, 93051 Regensburg (DE)
(74) Vertreter: Epping, Wilhelm
(86) Internationale Anmeldenummer: PCT/EP2011/070934
(87) Internationale Veröffentlichungsnummer: WO 2012/079956

(56) Entgegenhaltungen:
- WO-A1-2011/033023
- US-A1- 2004 086 745
- YULIA SEVRYUGINA ET AL: "Tetranuclear copper(i) clusters: impact of bridging carboxylate ligands on solid state structure and photoluminescence", CHEMICAL COMMUNICATIONS, Nr. 37, 1. Januar 2007 (2007-01-01), Seite 3853, XP55019644, ISSN: 1359-7345, DOI: 10.1039/b707957e
- SEVRYUGINA ET AL: "X-ray structure and photoluminescence of copper(I) 2,6-bis(trifluoromethyl)benzoate", INORGANICA CHIMICA ACTA, ELSEVIER BV, NL, Bd. 360, Nr. 9, 10. Mai 2007 (2007-05-10), Seiten 3103-3107, XP022067761, ISSN: 0020-1693, DOI: 10.1016/J.ICA.2007.02.023
- SHARMA R P ET AL: "Segregated aromatic @?@?@? stacking interactions involving fluorinated and non-fluorinated benzene rings: Cu(py)2(pfb)2 and Cu(py)2(pfb)2(H2O) (py=pyridine and pfb=pentafluorobenzoate)", JOURNAL OF FLUORINE CHEMISTRY, ELSEVIER, NL, Bd. 131, Nr. 4, 1. April 2010 (2010-04-01) , Seiten 456-460, XP026972104, ISSN: 0022-1139 [gefunden am 2010-01-04]

## Beschreibung

Die vorliegende Erfindung betrifft ein organisches lichtemittierendes Bauelement sowie die Verwendung eines Kupferkomplexes in einer Ladungstransportschicht eines elektronischen Bauelements mit transparentem Anodenkontakt.

Ein optoelektronisches Bauelement ist zur Umwandlung elektrischer Energie in elektromagnetische Strahlung, wie beispielsweise in sichtbares Licht, oder für den umgekehrten Prozess ausgelegt. Man kann jeweils von einer Emittervorrichtung oder einer Detektorvorrichtung sprechen. Ein Beispiel für ein elektromagnetisches Bauelement als Emittervorrichtung ist eine lichtemittierendes Bauelement, insbesondere eine lichtemittierenden Diode (LED). Das lichtemittierende Bauelement umfasst typischerweise Elektroden, zwischen denen eine aktive Zone angeordnet ist. Über die Elektroden kann dem lichtemittierenden Bauelement ein elektrischer Strom zugeführt werden, welcher in der aktiven Zone in optische Energie, d.h. elektromagnetische Strahlung gewandelt wird. Die optische Energie wird über eine Strahlungsauskopplungsfläche aus dem lichtemittierenden Bauelement ausgekoppelt.

Ein besonderes lichtemittierendes Bauelement ist das organische lichtemittierende Bauelement (*Organic Light Emitting Device* bzw. OLED). Eine OLED weist in der aktiven Schicht eine organische Schicht auf, um elektrische Energie in elektromagnetische Strahlung zu wandeln. Bei Kontaktierung der OLED über die Elektroden mit einer Stromquelle werden unterschiedliche Ladungsträgertypen in die organische Schicht injiziert. Positive Ladungsträger, auch als Löcher bezeichnet, wandern von der Anode hin zur Kathode durch die organische Schicht, während Elektronen die organische Schicht von der Kathode hin zur Anode durchwandern. Dabei bilden sich in der organischen Schicht Anregungszustände in Form von Elektronen-Lochpaaren, sogenannte Exzitonen, die unter Emission von elektromagnetischer Strahlung zerfallen. Ein solches organisches lichtemittierendes Bauelement ist beispielsweise aus dem Dokument [1] bekannt.

US 2004/086745 A1 (IWAKUMA TOSHIHIRO [JP] ET AL) 6. Mai 2004 (2004-05-06) offenbart auch ein lichtemittierendes Bauelement.

YULIA SEVRYUGINA ET AL: "Tetranuclear copper(i) clusters: impact of bridging carboxylate ligands on solid state structure and photoluminescence", Chem. Commun. 2007, 3853-3855, offenbart Kupferkomplexe der Formel I und deren Photolumineszenz Spektren.

SEVRYUGINA ET AL: "X-ray structure and photoluminescence of copper(I) 2,6-bis(trifluoromethyl)benzoate", Inorg. Chim. Acta, 2007, 360, 3103-3107, offenbart einen Kupferkomplex der Formel I und dessen Röntgenstruktur.

SHARMA R P ET AL: "Segregated aromatic π-π stacking interactions involving fluorinated and non-fluorinated benzene rings: Cu(py)2 (pfb)2 and Cu(py)2 (pfb)2 (H2 O) (py=pyridine and pfb=pentafluorobenzoate)",J. Fluor. Chem., 2010, 131, 456-460, offenbart auch Kupferkomplexe der Formel I und deren Röntgenstrukturen.

Die von der organischen Schicht emittierte elektromagnetische Strahlung wird über wenigstens eine der Elektroden, d.h. über die Anode oder die Kathode aus der OLED ausgekoppelt. Entsprechend muss die Elektrode transparent in Bezug auf die emittierte Strahlung sein, d.h. sie muss für die elektromagnetische Strahlung einen hohen Transmissionskoeffizienten aufweisen. Für elektromagnetische Strahlung im Bereich des sichtbaren Lichts werden für ein transparentes Elektrodenmaterial beispielsweise auf Silber (Ag), Gold (Au) oder Magnesium (Mg) basierende dünne Metallfilme (*thin metal film* bzw. TMF) verwendet. Ebenso ist eine Verwendung von transparenten leitfähigen Oxide (*transparent conductive oxide* bzw. TCO) als Elektrodenmaterial möglich, wie beispielsweise von Indiumzinnoxid (*Indium Tin Oxide* oder ITO) oder von aluminiumdotierten Zinkoxid (*Aluminum-doped zinc oxide* bzw. AZO). Weiterhin sind Kompositelektroden denkbar, die beispielsweise einen Schichtstapel aus TMFs und/oder TCOs aufweisen.

Um die Ladungsträger von der Elektrode in die aktive Schicht zu injizieren, sind häufig Zwischenschichten vorgesehen, mit denen ein Ladungsträgertransport von der Elektrode in die aktive Schicht bewirkt wird. Insbesondere anodenseitig ist eine solche Ladungstransportschicht wünschenswert, um die Injektion von Löchern in die aktive Schicht zu verstärken. Die anodenseitig vorgesehene Ladungstransportschicht wird auch als Lochtransportschicht (*hole transport layer* oder *HTL)* bezeichnet. Eine dicke HTL hat den Vorteil, im Betrieb der OLED spontane Kurzschlüsse zu unterdrücken, bei denen Elektronen - ohne mit Löchern in der aktiven Schicht zu Exzitonen zu kombinieren - die organische Schicht durchqueren und direkt an die Anode gelangen. Damit die Performanz von OLED-Bauteilen mit einer dicken HTL, beispielsweise in Bezug auf Effizienz oder auch Lebensdauer, gewährleistet werden kann, ist es vorteilhaft, wenn die relativ dicke Ladungstransportschicht zwischen Anode und aktiver Schicht möglichst transparent ist.

Der vorliegenden Erfindung liegt das Problem zugrunde, eine OLED bereitzustellen, bei der intrinsisch erzeugtes Licht über die Anode effizient ausgekoppelt werden kann, wobei sie sich durch eine hohe Spannungsstabilität auszeichnet.

Dieses Problem wird durch ein organisches lichtemittierendes Bauelement gemäß dem Patentanspruch 1 und durch die Verwendung eines Kupferkomplexes gemäß Patentanspruch 11 gelöst..

Weiterbildungen und vorteilhafte Ausgestaltungen des organischen lichtemittierenden Bauelements sind in den abhängigen Patentansprüchen angegeben.

### BEISPIELHAFTE AUSFÜHRUNGSFORMEN

Die verschiedenen Ausgestaltungen der nachfolgend beschriebenen Ausführungsformen gelten in gleicher Weise, soweit analog anwendbar, für das organische lichtemittierendes Bauelement und für die Verwendung des Kupferkomplexes in einer organischen Schichtstruktur.

Verschiedene Ausführungsformen des organisches lichtemittierendes Bauelements haben eine aktive Schicht zur Emission von elektromagnetischer Strahlung, eine Anode und eine zwischen der aktiven Schicht und der Anode angeordnete organische Ladungstransportschicht zum Ladungsträgertransport von der Anode in die aktive Schicht. Von der aktiven Schicht emittierte Strahlung ist über die Anode aus dem organischen lichtemittierenden Bauelement auskoppelbar. Die organische Ladungstransportschicht weist einen Kupferkomplex mit wenigstens einem Liganden mit der chemischen Struktur gemäß Formel I auf: 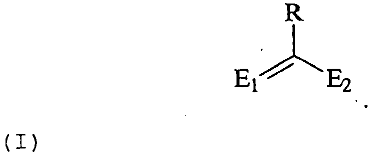 E₁ und E₂ sind jeweils unabhängig voneinander eines der folgenden Elemente: Sauerstoff, Schwefel oder Selen. R ist ausgewählt aus der Gruppe: Wasserstoff oder substituierte oder unsubstituierte, verzweigte, lineare oder zyklische Kohlenwasserstoffe. Weiterhin ist eine Kathode und eine zwischen der aktiven Schicht und der Kathode angeordnete elektronentransportierenden Schicht vorhanden, wobei die elektronentransportierende Schicht ein n-dotiertes Material aufweist.

Die Ladungstransportschicht kann eine p-dotierte Schicht darstellen, die den oben bezeichneten Kupferkomplex als p-Dotierstoff enthält. Der Kupferkomplex weist eine sehr gute Dotierfähigkeit auf. Er verbessert einen Ladungsträgertransport in der Ladungstransportsschicht, insbesondere wird die Leitfähigkeit von Löchern in dem p-dotierten Bereich erhöht. Insgesamt kann so die Ladungstransportschicht eine hohe Anzahl frei beweglicher Ladungsträger an der aktiven Schicht bereitstellen, wodurch eine besonders hohe Effizienz des organischen lichtemittierenden Bauelements erreicht wird. Weiterhin kann mit dem Kupferkomplex als Dotierstoff eine hohe Transparenz im Bereich der emittierten Strahlung erreicht werden. Der Transmissionskoeffizient eines mit dem Dotierstoff dotierten Matrixmaterials erlaubt eine Ladungstransportschicht mit einem Transmissionskoeffizienten von größer als 0,9 bereitzustellen. Die Verwendung des Kupferkomplexes als Dotierstoff bewirkt damit im Umkehrschluss eine Absorption von weniger als 10 % beim Durchgang der elektromagnetischen Strahlung durch die Ladungstransportschicht.

Durch die hohe Transparenz des Dotierstoffes kann eine dicke Ladungstransportschicht zwischen der Anode und der aktiven Schicht bereitgestellt werden, ohne hohe Absorptionsverluste in der Ladungstransportschicht hervorzurufen. Damit wird die Gestaltungsfreiheit bei dem Aufbau eines Schichtsystems in dem organischen lichtemittierenden Bauelement erhöht, insbesondere kann die Dicke der Ladungstransportschicht in Hinblick auf eine Spannungsstabilität des Bauelements erhöht werden, ohne hohe Absorptionsverluste hinnehmen zu müssen.

Ein weiterer Vorteil der Verwendung von Kupferkomplexen ist die leichte Verfügbarkeit der Ausgangsstoffe und die gefahrlose Verarbeitung der Dotierstoffe, so dass eine kostengünstige und umweltschonende Alternative zu bereits bekannten Dotierstoffen genutzt werden kann.

In einigen Ausführungsformen ist der Kupferkomplex ein Kupfer(I)penta-Fluor-Benzoat. Dieses weist die folgende Struktur auf: 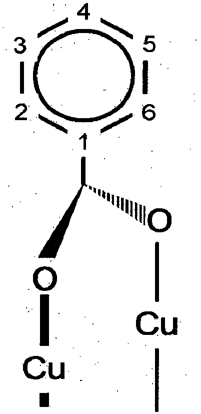 wobei die Positionen 2 bis 6 durch eine Fluorierung besetzt sind. Die Auswahl des Kupfer(I)penta-Fluor-Benzoats ist vor allem deswegen vorteilhaft, weil mit diesem Komplex eine hohe Löcher-Leitfähigkeit und eine geringe Absorption im sichtbaren Spektralbereich verbunden ist. Für eine 100 nm dicke Schicht aus (4,4',4" -tris(N-(1-naphthyl)-N-phenyl-amino)Triphenylamin, das mit Kupfer(I)penta-Fluor-Benzoat dotiert wurde, konnte eine Transmission von mehr als 93% oberhalb einer Wellenlänge von 420nm gemessen werden.

Weiterhin ist Kupfer(I)penta-Fluor-Benzoat besonders für eine Verarbeitung bei der Herstellung eines organischen lichtemittierenden Bauelements geeignet. Es hat eine Verdampfungstemperatur von lediglich ca. 200°C. Andere für eine p-Dotierung verwendete Dotierstoffe, wie V₂O₅, MoO₃, WO₃ oder F4-TCNQ(2,3,5,6-Tetrafluoro-7,7,8,8-Tetracyanoquinodimethan) weisen eine wesentlich höhere Verdampfungstemperatur auf. Kupfer(I)penta-Fluor-Benzoat kann daher ohne die Verwendung besonderer Hochtemperatur-Verdampfungsquellen verarbeitet werden.

Die Dotierkonzentration des Dotierstoffes in dem Material kann dabei hinsichtlich der elektrischen Leitfähigkeit und der Stabilität der Ladungstransportschicht optimal gewählt sein. In besonders vorteilhaften Ausführungsformen liegt die Dotierkonzentration zwischen 0,1 bis 50 Gewichtsprozent der Ladungstransportschicht. Besonders vorteilhaft hat sich ein Wert von ca. 5 Gewichtsprozent erwiesen.

Weiterhin kann mittels der Dotierkonzentration die Transparenz des Ladungstransportschicht erhöht werden. Eine hohe Transparenz ist notwendig, um Absorptionsverluste in der Ladungstransportschicht zu vermeiden. Dabei ist es vorteilhaft, eine besonders hohe Dotierkonzentration in der Ladungstransportschicht bereitzustellen. Die Dotierkonzentration sollte bei mindestens 1, vorteilhafterweise bei mehr als 10 Gewichtsprozent der Ladungstransportschicht liegen.

In einigen Ausführungsformen weist die Ladungstransportschicht einen Dotierungsgradienten hin zu der aktiven Schicht auf. Das bedeutet, dass die Konzentration des Dotierstoffes sich über den Querschnitt der Ladungstransportschicht verändert. Vorteilhafterweise nimmt die Dotierung der Ladungstransportschicht hin zu der aktiven Schicht ab. Damit wird insbesondere an der Grenzfläche der Ladungstransportschicht zu der Anode eine hohe Dotierkonzentration bereitgestellt, die eine hinreichend leichte Injektion aus der Anode in die Ladungstransportschicht ermöglicht.

Ein Dotiergradient kann dabei beispielsweise durch das Aufbringen mehrerer p-dotierter organischer Halbleiterschichten übereinander erzielt werden. Ebenso ist es denkbar, dass während eines Herstellprozesses der Ladungstransportschicht die Zufuhr des Dotierstoffes durch einen geeigneten Prozess verändert wird, so dass mit zunehmender Schichtdicke eine graduell andere Dotierung der Ladungstransportschicht erfolgt. Ebenso ist es denkbar, dass durch eine geeignete Zufuhr, beispielsweise durch ein Strahlprofil bei der Implantation des Dotierstoffs, eine gewünschte Verteilung des Dotierstoffes in dem Matrixmaterial erhalten wird.

Die Dotierstoffkonzentration kann beispielsweise von 100% an der Anodenseite bis 0% an der Grenzfläche zur aktiven Schicht verlaufen. Es ist beispielsweise anodenseitig in der Ladungstransportschicht ein dünner Dotierstofffilm denkbar. Es ist zusätzlich denkbar, dass unterschiedliche Dotierstoffe in der Ladungstransportschicht eingebracht sind, und dass so ein eine Variation in der Leitfähigkeit oder eine geeignete Gestaltung der Potentialbarrieren zur Anode und zur aktiven Schicht bewirkt wird.

### KURZE BESCHREIBUNG DER ZEICHNUNG

Ein Ausführungsbeispiel des organischen lichtemittierenden Bauelements wird im Folgenden anhand der Zeichnung näher erläutert. Dabei zeigen
- **Fig.1**: eine schematische Darstellung eines ersteh Ausführungsbeispiels eines organischen lichtemittierenden Bauelements und
- **Fig.2**: eine schematische Darstellung eines zweiten Ausführungsbeispiels eines organischen lichtemittierenden Bauelements.

### ERSTES AUSFÜHRUNGSBEISPIEL EINES ORGANISCHEN LICHTEMITTERENDEN BAUELEMENTS

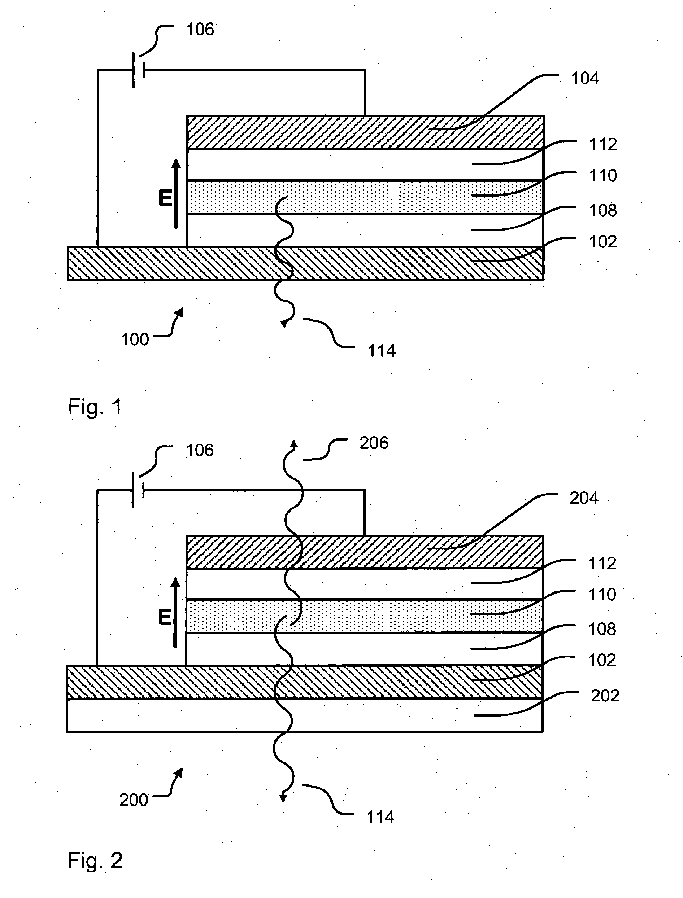

**Fig.1** zeigt eine schematische Darstellung eines ersten Ausführungsbeispiels eines organischen lichtemittierenden Bauelements 100.

Das organische lichtemittierende Bauelement 100 weist eine Anode 102 und eine Kathode 104 auf. Die Anode 102 und die Kathode 104 dienen als Elektroden des organischen lichtemittierenden Bauelements 100. Sie sind mit einer externen Stromquelle 106 verbunden, beispielsweise mit einer Batterie oder mit einem Akkumulator. Zwischen der Anode 102 und der Kathode 104 ist ein Schichtstapel aus organischen und/oder anorganischen Halbleitermaterialien angeordnet. Die Anode 102 und die Kathode 104 weisen jeweils ein gut leitfähiges Material auf, das hinsichtlich seiner optischen Eigenschaften gewählt sein kann. Dabei weist die Anode 102 ein transparentes Material auf. Sie kann ein TMF, ein TCO und/oder ein transparentes, leitfähiges Polymer enthalten. Ebenso kann die Kathode 104 aus einem transparenten Material bestehen. Es ist ebenso denkbar, dass die Kathode 104 aus einem hochleitfähigen, reflektierenden Material besteht, das beispielsweise ein Metall, etwa Aluminium, Silber, Platin, Kupfer oder Gold, oder eine Metalllegierung enthält.

Über die Anode 102 werden positive Ladungsträger (Löcher) in den Schichtstapel injiziert, während über die Kathode 104 negative Ladungsträger (Elektronen) in den Schichtstapel injiziert werden. Gleichzeitig liegt zwischen der Anode 102 und der Kathode 104 ein elektrisches Feld E an. Das elektrische Feld E bewirkt, dass aus der Anode 102 injizierte Löcher durch den Schichtstapel in Richtung der Kathode 104 wandern. Aus der Kathode 104 injizierte.Elektronen wandern unter Einfluss des elektrischen Feldes E in Richtung der Anode 102.

Der Schichtstapel weist eine Reihe unterschiedlicher funktioneller Schichten auf. Unmittelbar auf der Anode 102 ist eine lochtransportierende Schicht 108 aufgebracht. Auf der lochtransportierenden Schicht 108 ist eine aktive Schicht 110 aufbracht. Zwischen der aktiven Schicht 110 und der Kathode 104 ist eine elektronentransportierende Schicht 112 angeordnet.

Bei der Ausgestaltung des organischen lichtemittierenden Bauelements 100 ist es denkbar, dass weitere funktionelle Schichten vorgesehen sein können. Diese können beispielsweise zur Injektion von Ladungsträger in benachbarte Schichten oder bei zum verbesserten oder begrenzten Transport von Ladungsträgern in benachbarte Schichten dienen. Ebenso ist das Vorsehen von Schichten zum Bereitstellen weiterer Ladungsträger, wie beispielsweise einer sogenannten *charge generation layer* bzw. CGL, denkbar.

### LOCHTRANSPORTIERENDE SCHICHT 108

Die Funktion der lochtransportierenden Schicht 108 besteht vorrangig darin, einen balancierten Transport von positiven Ladungsträgern in die aktive Schicht 110 sicherzustellen. Die lochtransportierende Schicht 108 kann ein p-dotiertes Matrixmaterial sein. Als p-Dotierstoff dient ein Kupferkomplex mit wenigstens einem Liganden mit der chemischen Struktur gemäß Formel I:

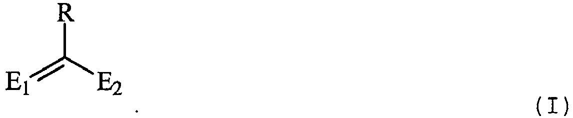

E₁ und E₂ sind jeweils unabhängig voneinander eines der folgenden Elemente: Sauerstoff, Schwefel oder Selen. R ist ausgewählt aus der Gruppe: Wasserstoff oder substituierte oder unsubstituierte, verzweigte, lineare oder zyklische Kohlenwasserstoffe.

Dabei können die folgenden Materialien als Teil des Matrixmaterials verwendet werden:

NPB (N,N'-bis(1-naphthyl)-N,N'-bis(phenyl)-Benzidin, β-NPB (N,N'-bis(naphthalen-2-yl)-N,N'-bis(phenyl)-Benzidin), TPD (N,N'-bis(3-methylphenyl)-N,N'-bis(phenyl)-Benzidin), N,N'-bis(1-naphthyl)-N,N'-bis(phenyl)-2,2-Dimethylbenzidin, Spiro-TPD (N,N'-bis(3-methylphenyl)-N,N'-bis(phenyl)-9,9-Spirobifluoren), Spiro-NPB (N,N'-bis(1-naphthyl)-N,N'-bis(phenyl)-9,9-Spirobifluoren), DMFL-TPD (N,N'-bis(3-methylphenyl)-N,N'-bis(phenyl)-9,9-Dimethylfluoren, DMFL-NPB (N,N'-bis(1-naphthyl)-N,N'-bis(phenyl)-9,9-Dimethylfluoren), DPFL-TPD (N,N'-bis(3-methylphenyl)-N,N'-bis(phenyl)-9,9-Diphenylfluoren), DPFL-NPB (N,N'-bis(naphth-1-yl)-N,N'-bis(phenyl)-9,9-Diphenylfluoren), Sp-TAD (2,2',7,7'-tetrakis(n,n-diphenylamino)-9,9'-Spirobifluoren), TAPC (di-[4-(N,N-ditolyl-amino)-phenyl]Cyclohexan), Spiro-TTB (2,2',7,7'-tetra(N, N-di-tolyl)Amino-Spiro-Bifluoren), BPAPF (9,9-bis[4-(N,N-bis-biphenyl-4-yl-amino)phenyl]-9H-Fluoren), Spiro-2NPB (2,2',7,7'-tetrakis[N-naphthyl(phenyl)-amino]-9,9-Spirobifluoren), Spiro-5 (2,7-bis[N,N-bis(9,9-spiro-bifluoren-2-yl)-amino]-9,9-Spirobifluoren), 2,2'-Spiro-DBP (2,2'-bis[N,N-bis(biphenyl-4-yl)amino]-9,9-Spirobifluoren), PAPB (N, N'-bis(phenanthren-9-yl)-N,N'-bis(phenyl)-Benzidin), TNB (N, N,N',N'-tetra-naphthalen-2-yl-Benzidin), Spiro-BPA (2,2'-bis(N,N-di-phenyl-amino)-9,9-Spirobifluoren), NPAPF (9,9-Bis[4-(N,N-bis-naphthyl-amino)phenyl]-9H-Fluoren), NPBAPF (9,9-bis[4-(N, N'-bis-naphth-2-yl-N,N'-bis-phenyl-amino)-phenyl]-9H-Fluoren), TiOPC (Titanoxid-Phthalocyanin), CuPC (Kupferphthalocyanin), F4-TCNQ (2,3,5,6-tetrafluor-7,7,8,8,-tetracyano-Quinodimethan), m-MTDATA (4,4',4" -tris(N-3-methylphenyl-N-phenyl-amino)Triphenylamin), 2T-NATA (4,4',4"-tris(N-(naphthalen-2-yl)-N-phenyl-amino)Triphenylamin), 1-TNATA (4,4',4" -tris(N-(1-naphthyl)-N-phenyl-amino)Triphenylamin), NATA (4,4',4" -tris(N,N-diphenyl-amino)Triphenylamin), PPDN (pyrazino[2,3-f][1,10]phenanthrolin-2,3-Dicarbonitril), MeO-TPD (N, N, N' ,N' -tetrakis(4-methoxyphenyl)-Benzidin), MeO-Spiro-TPD (2,7-bis[N,N-bis(4-methoxy-phenyl)amino]-9,9-Spirobifluoren), 2,2'-MeO-Spiro-TPD (2,2'-bis[N,N-bis(4-methoxy-phenyl)amino]-9,9-Spirobifluoren), β - NPP (N, N'-di(naphthalen-2-yl)-N,N'-diphenylbenzen-1,4-Diamin), NTNPB (N,N'-di-phenyl-N,N'-di-[4-(N, N-di-tolyl-amino)phenyl]-Benzidin) oder NPNPB (N,N'-di-phenyl-N,N'-di-[4-(N, N-di-phenyl-amino)phenyl]-Benzidin).

Der oben genannte Kupferkomplex ist im Verhältnis zu dem Matrixmaterial der zweiten organischen Halbleiterschicht 104 ein metallo-organischer Akzeptorverbund. Er dient als p-Dotierstoff. Dabei kann der Kupferkomplex ein isoliertes Molekül sein. Häufig wird der Kupferkomplex über chemische Bindungen mit Molekülen des Matrixmaterials verbunden sein, beispielsweise indem Moleküle des Matrixmaterials als Liganden einen Teil des Kupferkomplexes bilden. Üblicherweise komplexiert das Kupferatom mit organischen Liganden. Die organischen Liganden können geeignete funktionelle Gruppen bilden, so dass eine Verbindung zu einem Oligomer oder einem Polymer ermöglicht ist.

Der Kupferkomplex kann einen einzähnigen, dreizähnigen oder einen vierzähligen Liganden aufweisen. Insbesondere kann er eine oder mehrere Gruppen C(=E₁)E₂ enthalten, wobei wenigstens eins oder mehrere der Donatoratome E₁ und E₂ der Liganden und die Kupferatome komplexieren. Die C(=E₁)E₂-Grüppe weist dabei üblicherweise eine negative Ladung auf. Ebenso können auch nicht-deprotonierte Carboxylsäuren oder Homologe von diesen als Liganden des Kupferkomplexes dienen. Allgemein trägt der Ligand des Kupferkomplexes negative Ladung in den Komplex bei, beispielsweise durch eine negative Ladung pro Carboxylgruppe bzw. pro homologer Carboxylgruppe.

Soweit sich keine Moleküle des Matrixmaterials mit den Kupferatomen verbinden, ist der Kupferkomplex ein homoleptischer Komplex, bei dem allein Liganden mit dem zentralen Kupferatom komplexieren. Oft weist ein solcher Komplex eine rechteckige oder linearer Molekülgeometrie auf. Dies gilt besonders, wenn Wechselwirkungen zwischen Kupferatomen.vernachlässigbar sind. Soweit Moleküle aus dem Matrixmaterial mit dem zentralen Kupferatom verbinden, nimmt die Molekülgeometrie des Komplexes die Form einer pentagonalen Bipyramide an oder der Komplex erhält eine quadratischpyramidiale Molekülgeometrie. Dabei ist der Kupferkomplex gewöhnlich ein elektrisch neutraler Komplex.

Der Kupferkomplex kann sowohl ein mononuklearer Kupferkomplex als auch ein polynuklearer Kupferkomplex sein. In einem polynuklearen Kupferkomplex kann der Ligand lediglich mit einem Kupferatom oder mit zwei Kupferatomen verbunden sein. Dabei kann der Ligand beispielsweise eine Brücke zwischen zwei Kupferatomen bilden. Sollte der Ligand dreioder mehrzählig sein, kann er auch mehr Kupferatome als Brücke verbinden. Im Fall eines polynuklearen Kupferkomplexes können Kupfer-Kupfer-Verbindungen zwischen zwei oder mehreren Kupferatomen bestehen. Die Verwendung polynuklearer Kupferkomplexe ist deswegen besonders vorteilhaft, weil eine derart dotierte organische Funktionsschicht eine höhere Lebensdauer als eine mit einem mononuklearen Kupferkomplex dotierte Funktionsschicht aufweist. Dies kann durch eine Destabilisierung des Komplexes bei einem Ladungstransport durch die Funktionsschicht erklärt werden. Die Wirkung des Ladungstransports wird im Fall polynuklearer Kupferkomplexe nicht nur auf ein sondern auf mehrere Kupferkomplexe verteilt.

Ein polynuklearer Kupferkomplex kann eine sogenannte "*paddel-wheel*/Schaufelrad"-Struktur aufweisen. Dies gilt insbesondere im Fall eines Kupfer(II)-Komplexes. Üblicherweise wird eine Schaufelrad-Struktur in einem Komplex mit zwei Metallatomen angenommen, wobei zwei Kupferatome mit einem oder mehr mehrzähligen Liganden als Brücke verbunden sind.

Häufig ist der Koordinationsmodus aller Liganden hinsichtlich des Kupferatoms fast identisch. Damit wird hinsichtlich der Kupferatome und der Liganden wenigstens eine zweizählige oder vierzählige Drehachse durch zwei der Kupferatome des polynuklearen Kupferkomplexes definiert. Dabei weisen quadratisch-planare Komplexe oft eine wenigstens vierzählige Drehachse auf, während linear-koordinierte Komplexe häufig eine zweizählige Drehachse aufweisen.

Das Kupferatom eines mononuklearen Komplexes oder wenigstens eines Kupferatoms eines polynuklearen Kupferkomplexes kann eine Oxidationsstufe +2 aufweisen. In solchen Komplexen sind die Liganden häufig in einer quadratisch-planaren Geometrie koordiniert. Weist das Kupferatom eine Oxidationsstufe +1 auf, ist das Kupferatom häufig linear koordiniert.

Kupferkomplexe mit einem Cu(II)-Atom weisen in aller Regel eine höhere Lochleitfähigkeit auf als Kupferkomplexe mit einem Cu(I)-Atom. Letztere haben eine abgeschlossene d¹⁰-Schale. Die Lochleitfähigkeit ist vorrangig durch die durch die Cu(I)-Atome entstehende Lewis-Säure verursacht. Cu(II)-Komplexe weisen dagegen eine nicht-aufgefüllte d⁹-Konfiguration auf, wodurch ein Oxidationsverhalten verursacht wird. Eine teilweise Oxidation erhöht die Lochdichte. Die Verwendung von Cu(I)-Komplexen kann jedoch vorteilhaft sein, weil Cu(I)-Komplexe häufig thermisch stabiler sind als korrespondierende Cu(II)-Komplexe.

Den beschriebenen Kupferkomplexen ist gemein, dass sie eine Lewis-Säure sind. Eine Lewis-Säure ist eine Verbindung, die als Elektronenpaar-Akzeptor wirkt. Das Verhalten der Kupferkomplexe als Lewis-Säure ist mit den Molekülen des Matrixmaterials verknüpft, in das der Kupferkomplex als Dotierstoff eingebracht ist. Die Moleküle des Matrixmaterials wirken in der Regel als Lewis-Base in Bezug auf die Lewissauren Kupfermoleküle. Eine Lewis-Base ist ein Elektronenpaar-Donator.

Das Kupferatom in dem Kupferkomplex besitzt eine offene, d.h. weitere Koordinationsstelle. Au diese Koordinationsstelle kann sich eine Lewisbasische Verbindung binden, beispielsweise ein aromatisches Ringsystem, ein Stickstoffatom oder eine Aminkomponente, die in dem Matrixmaterial enthalten sind. Dies ist beispielhaft in den Abbildungen 1 und 2 dargestellt: 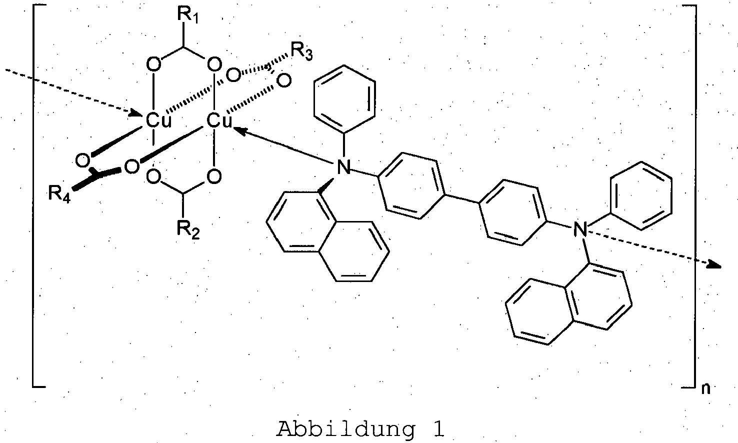 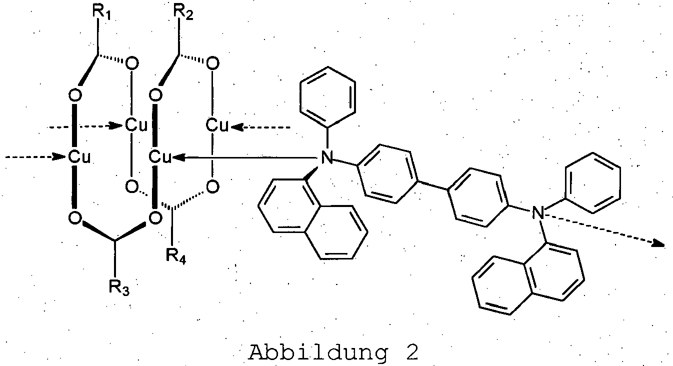 Es können auch Gruppen mit heteroaromatischen Ringsystemen oder ein Stickstoffatom einer Aminkomponente mit einem Kupferatom koordinieren.

Der an das Kupferatom koordinierende Ligand kann eine Gruppe R aufweisen, die eine substituierte oder unsubstituierte Kohlenwasserstoffgruppe aufweist. Die Kohlenwasserstoffgruppe kann eine lineare, verzweigte oder zyklische Gruppe sein. Diese kann 1 - 20 Kohlenstoffe aufweisen. Beispielsweise ist sie eine Methyl- oder Ethylgruppe. Sie kann auch kondensierte Substituenten aufweisen, wie Decahydronaphthyl, Adamantyl, Cyclohexyl oder teilweise bzw. vollständig substituierte Alkylgruppen. Die substituierten oder unsubstituierten aromatischen Gruppen sind beispielsweise Phenyl, Biphenyl, Naphthyl, Phenanthryl, Benzyl oder ein heteroaromatischer Rest, beispielsweise ein substituierter oder unsubstituierter Rest, der aus den Heterozyklen der Abbildung 3 ausgewählt sein kann:

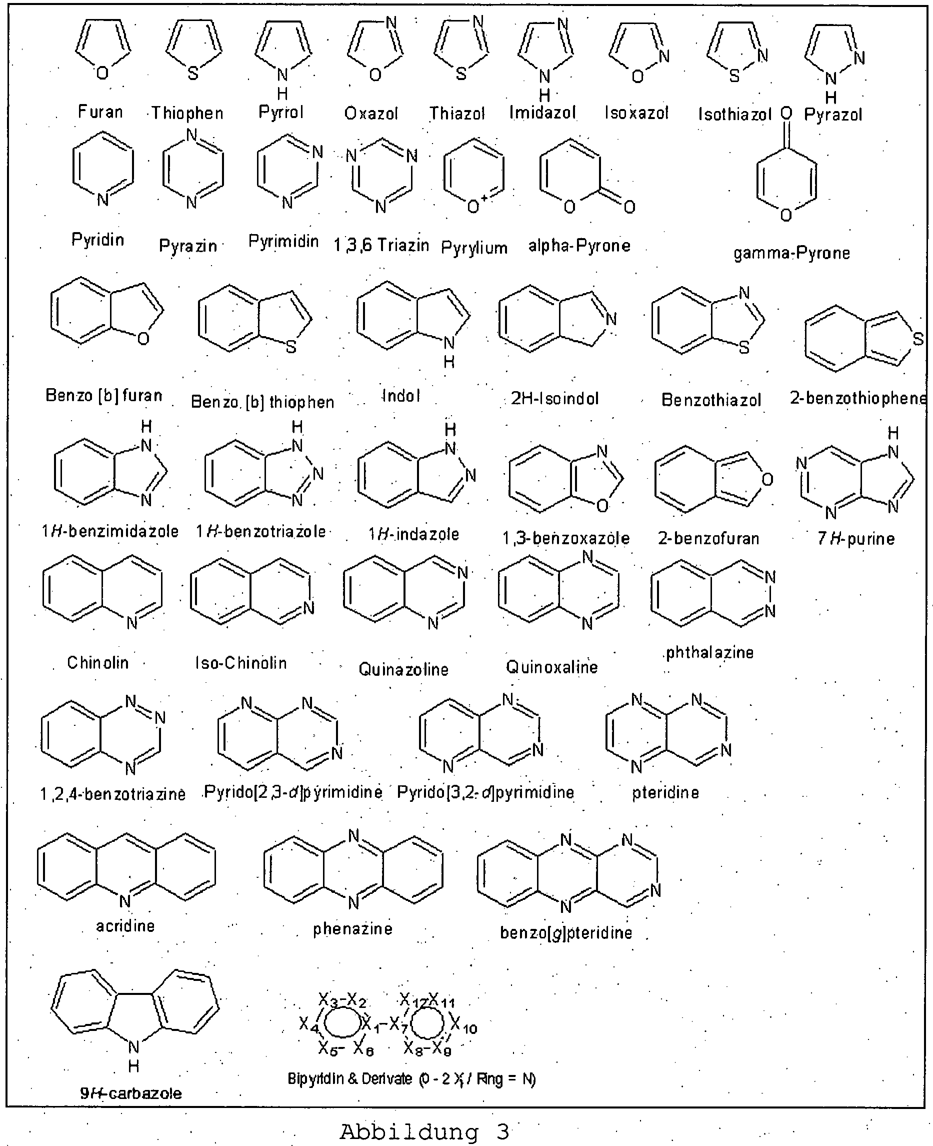

Der an das Kupferatom koordinierende Ligand kann auch eine Gruppe R aufweisen, die eine Alkyl- und/oder eine Arylgruppe umfasst. Die Alkyl- und/oder Arylgruppe enthält wenigstens einen elektronenentziehenden Substituenten. Der Kupferkomplex kann ebenfalls als gemischtes System eine oder mehrere Typen einer Carbonsäure enthalten

Ein elektronenentziehender Substituent wird in der vorliegenden Offenbarung als ein Substituent verstanden, der die Elektronendichte in einem an den Substituenten gebundener Atom gegenüber einer Konfiguration, in der an Stelle des elektronenentziehenden Substituenten ein Wasserstoffatom an das Atom bindet.

Eine elektronenentziehende Gruppe kann beispielsweise aus der folgenden Gruppe ausgewählt sein: Halogene, wie Chlor oder insbesondere Fluor, Nitrogruppen, Cyanogruppen oder Mischungen dieser Gruppen. Die Alkyl- bzw. Arylgruppe können ausschließlich elektronenentziehende Substituenten, wie die genannten elektronenentziehenden Gruppen, oder Wasserstoffatome enthalten. Wenn der Ligand eine Alkyl- und/oder Arylgruppe mit wenigstens einem elektronenentziehenden Substituenten aufweist, so wird die Elektronendichte an dem oder den Kupferatom(en) reduziert, wodurch der Lewis-Säuregrad des Komplexes erhöht wird.

Der Ligand kann dabei ein Anion der Kohlensäuren CHalₓH₃₋ₓCOOH, insbesondere CFₓH₃₋ₓCOOH und CClₓH₃₋ₓCOOH, repräsentieren wobei Hal ein Halogenatom und x eine ganze Zahl von 0 bis 3 sind. Auch kann der Ligand ein Anion der Kohlensäuren CR'_{y}HalₓH_{3-x-y}COOH, wobei Hal ein Halogenatom, x eine ganze Zahl von 0 bis 3 und y eine ganze Zahl wenigstens mit dem Wert 1 ist. Die Restgruppe R' ist eine Alkylgruppe, ein Wasserstoffatom oder eine aromatische Gruppe, wie beispielsweise eine Phenylgruppe oder alle bisher beschriebenen Substituentengruppen. Sie kann elektronenentziehende Substituenten enthalten, insbesondere die weiter oben beschriebenen elektronenentziehenden Substituenten. Sie kann auch ein Derivat der Benzoesäure mit einem elektronenentziehenden Substituenten enthalten. Beispielsweise kann der Ligand ein Anion der Kohlensäure R'-(CF₂)ₙ-CO₂H sein, wobei n einen ganzzahligen Wert zwischen 1 und 20 annimmt. Beispielsweise kann eine fluorierte, insbesondere eine perfluorierte, homo- oder heteröaromatische Verbindung als Restgruppe verwendet werden. Ein Beispiel sind Anionen einer fluorierten Benzoesäure: 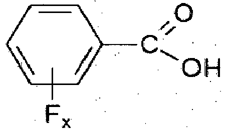 wobei x einen ganzahligen Wert von 1 bis 5 annimmt. Insbesondere können die folgenden Substituenten, bzw. solche bei denen Fluor durch Chlor ersetzt wurde, an die Carboxylgruppe binden, die alle starke Lewissäuren sind:

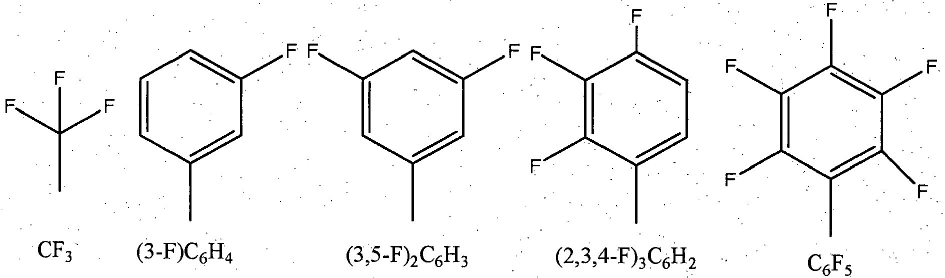

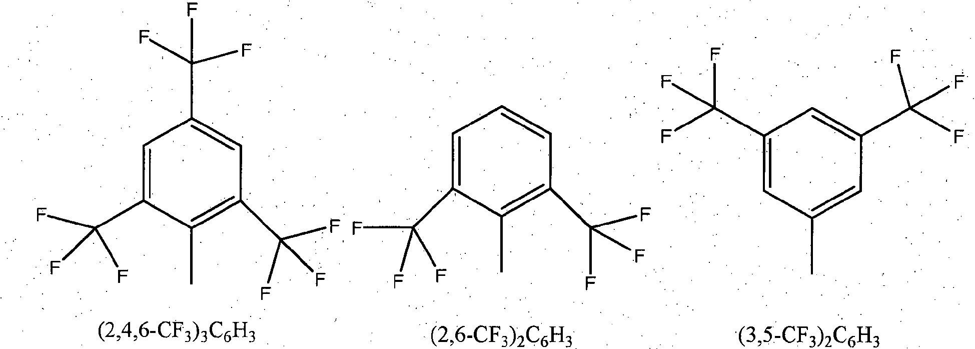

Weiterhin können Anionen der folgenden Säure als Liganden verwendet werden: 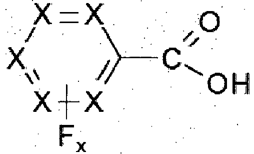 wobei X ein Stickstoff oder ein Kohlenstoffatom sein kann, das beispielsweise an ein Wasserstoffatom oder ein Fluoratom bindet. Beispielhaft können drei der Atome X für ein Stickstoffatom und zwei für eine C-F-Bindung oder C-H-Bindung (als Triazinderivate) stehen. Auch können Anionen der folgenden Säure als Liganden verwendet werden: 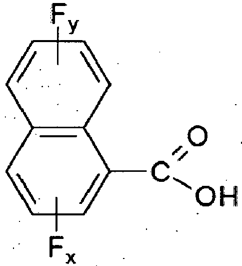 wobei der Naphtylring mit 1 bis 7 Fluorsubstituenten substituiert ist, so dass gilt y = 0 - 4 und x = 0 - 3, wobei y+x = 1 -7.

Fluor und Fluorverbindungen als elektrohenentziehende Substituenten sind insbesondere deshalb vorteilhaft, weil Kupferkomplexe, die Fluoratome enthalten, bei einer Herstellung des organischen lichtemitterende Bauelements leicht verdampft und in einer organischen Schicht abgelagert werden können. Als weitere oder alternative Substituentengruppe kann eine Trifluormethylgruppe genannt werden.

### ELEKTRONENTRANSPORTIERENDE SCHICHT 112

Die Funktion der elektronentransportierenden Schicht 112 besteht vorrangig darin, einen balancierten Transport von negativen Ladungsträgern in die aktive Schicht 110 sicherzustellen. Dazu kann die elektronentransportierende Schicht 112 ein n-dotiertes Material aufweisen. Für die n-Dotierung können Metalle mit geringer Austrittsarbeit, beispielsweise Cäsium, Lithium oder Magnesium verwendet werden. Ebenfalls sind Verbindungen als n-Dotierstoff geeignet, die diese Metalle enthalten, so beispielsweise Cs₂CO₃, CsF oder LiF. Diese Dotierstoffe sind in ein Matrixmaterial eingebracht. Als Matrixmaterial ist beispielsweise TPBi(1,3,5-Tris(1-phenyl-1H-benzimidazol-2-yl)Benzen) geeignet.

### AKTIVE SCHICHT 110

Die aktive Schicht 110 weist eine lichtemittierende Schicht auf, die ein organisches Elektrolumineszenzmaterial umfasst. In dem Elektrolumineszenzmaterial wird aufgrund einer Bildung von Exzitonen und in einem ein anschließenden Zerfall eine Emission elektromagnetischer Strahlung 114 hervorgerufen. Die elektromagnetische Strahlung 114 tritt durch die lochtransportierende Schicht 108 und die Anode 102 aus dem organischen lichtemittierenden Bauelement 100 aus.

Die Auswahl des Elektrolumineszenzmaterials ist ein sich fortlaufend weiterentwickelnder Bereich. Zu Beispielen für derartige organische Elektrolumineszenzmaterialien zählen:
- (i) Poly(p-phenylenvinylen) und seine Derivate, an verschiedenen Positionen an der Phenylengruppe substituiert;
- (ii) Poly(p-phenylenvinylen) und seine Derivate, an verschiedenen Positionen an der Vinylengruppe substituiert;
- (iii) Poly(p-phenylenvinylen) und seine Derivate, an verschiedenen Positionen an der Phenylenkomponente und auch an verschiedenen Positionen an der Vinylengruppe substituiert;
- (iv) Polyarylenvinylen, wobei es sich bei dem Arylen um solche Gruppen wie etwa Naphthalin, Anthracen, Furylen, Thienylen, Oxadiazol und dergleichen handeln kann;
- (v) Derivate von Polyarylenvinylen, wobei das Arylen wie in (iv) oben sein kann und zusätzlich Substituenten an verschiedenen Positionen an dem Arylen aufweisen kann;
- (vi) Derivate von Polyarylenvinylen, wobei das Arylen wie in (iv) oben sein kann und zusätzlich Substituenten an verschiedenen Positionen an dem Vinylen aufweisen kann;
- (vii) Derivate von Polyarylenvinylen, wobei das Arylen wie in (iv) oben sein kann und zusätzlich Substituenten an verschiedenen Positionen an dem Arylen und Substituenten an verschiedenen Positionen an dem Vinylen aufweisen kann;
- (viii) Copolymere von Arylen-Vinylen-Oligomeren wie etwa solche in (iv), (v), (vi) und (vii) mit nichtkonjugierten Oligomeren; Und
- (ix) Poly(p-phenylen) und seine Derivate, an verschiedenen Positionen an der Phenylengruppen substituiert, einschließlich Leiterpolymerderivate wie etwa Poly(9,9-dialkylfluoren) und dergleichen;
- (x) Polyarylene, wobei es sich bei dem Arylen um solche Gruppen wie Naphthalin, Anthracen, Furylen, Thienylen, Oxadiazol und dergleichen handeln kann; und ihre an verschiedenen Positionen an der Arylengruppe substituierten Derivate;
- (xi) Copolymere von Oligoarylenen wie etwa solche in (x) mit nichtkonjugierten Oligomeren;
- (xii) Polychinolin und seine Derivate;
- (xiii) Copolymere von Polychinolin mit p-Phenylen, substituiert an dem Phenylen mit beispielsweise Alkyl- oder Alkoxygruppen, um Löslichkeit zu erhalten; und
- (xiv) Starre Stabpolymere wie etwa Poly(p-phenylen-2,6-benzobisthiazol), Poly(p-phenylen-2,6-benzobisoxazol), Poly(p-phenylen-2,6-benzimidazol) und ihre Derivate.

Zu anderen organischen emittierenden Polymeren wie etwa solchen, die Polyfluoren verwenden, zählen Polymere, die grünes, rotes, blaues oder weißes Licht emittieren, oder ihre Familien, Copolymere, Derivate oder deren Mischungen. Zu anderen Polymeren zählen Polyspirofluoren-artige Polymere.

Alternativ können anstatt Polymeren kleine organische Moleküle, die über Fluoreszenz oder über Phosphoreszenz emittieren, als die organische Elektrolumineszenzschicht dienen. Zu Beispielen für kleinmölekülige organische Elektrolumineszenzmaterialien zählen:
(i) Tris(8-hydroxychinolinato)aluminium, (Alq);
(ii) 1,3-Bis(N,N-dimethylaminophenyl)-1,3,4-oxidazol (OXD-8);
(iii) -Oxo-bis(2-methyl-8-chinolinato)aluminium;
(iv) Bis(2-methyl-8-hydroxychinolinato)aluminium;
(v) Bis(hydroxybenzochinolinato)beryllium (BeQ.sub.2);
(vi) Bis(diphenyl-vinyl)biphenylen (DPVBI); und
(vii) Arylamin-substituiertes Distyrylarylen (DSA-Amin).

Die aktive Schicht 110 kann eine weiß-emittierende Schicht sein. Das bedeutet, dass sie elektromagnetische Strahlung 114 im gesamten sichtbaren Spektrum emittiert. Dies kann beispielsweise durch ein Stapeln mehrerer aktiver Einzelschichten erzielt werden, wobei in jeder Einzelschicht jeweils ein Farbspektrum erzeugt wird. Ebenso ist es denkbar, dass unterschiedlicher Emittermaterialien zur Erzeugung verschiedener Farbspektren in einer aktiven Schicht 110 gemischt sind.

In dem Ausführungsbeispiel wird ein Kupferkomplex in einer Ladungstransportschicht eines optoelektronischen Bauelements mit transparentem Anodenkontakt und einer zwischen einer aktiven Schicht und einer Kathode angeordneten elektronentransportierenden Schicht, wobei die elektronentransportierende Schicht ein n-dotiertes Material aufweist, verwendet. Der Kupferkomplex weist dabei wenigstens einen Liganden mit der chemischen Struktur gemäß Formel I auf: 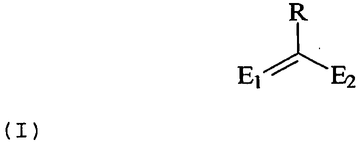 worin E₁ und E₂ jeweils unabhängig voneinander eines der folgenden Elemente sind: Sauerstoff, Schwefel oder Selen, und R ausgewählt ist aus der Gruppe: Wasserstoff oder substituierter oder unsubstituierter, verzweigter, linearer oder zyklischer Kohlenwasserstoffe.

Dabei kann der Kupferkomplex insbesondere in einer Ladungstransportschicht eines invertierten oder eines transparenten organischen lichtemittierenden Bauelements verwendet werden. Der Kupferkomplex kann als p-Dotierstoff in ein Matrixmaterial eingebracht sein. Durch die bereits beschriebenen Eigenschaften des Kupferkomplexes kann ein Bauelement mit hoher Effizienz, guter Spannungsstabilität und langer Lebensdauer bereitgestellt. Durch die Verwendung des Kupferkomplexes in einer p-dotierten Schicht wird zusätzlich ein anfänglich starker Leuchtdichteabfall bei einer ersten Inbetriebnahme des Bauelements (auch bekannt als *initial drop*) vermeiden. Es kann insbesondere auch eine in Abhängigkeit der Alterung annähernd lineare Abnahme der Leuchtdichte des Bauelements erreicht werden.

Durch die Verwendung des Kupferkomplexes ist es weiterhin möglich TCO-Materialien als Einzelschicht oder als Teil einer Kompositelektrode mit Hilfe von Sputtertechnologien oder mittels Atomlagendeposition (*atomic layer deposition* oder ALD) als Top-Anode auf das Bauelement aufzubringen. Dadurch wird es möglich ein organisches lichtemittierendes Bauelement mit einer geringen Blickwinkelabhängigkeit der Emissionsfarben und guter Effizienz herzustellen. Auch lassen sich großflächige Bauelemente herstellen, bei denen auf metallische Leiterbahnen, wie beispielsweise sogenannte *busbars* verzichtet werden kann. Weiterhin lassen sich transparente organische lichtemittierende Bauelemente mit einer Transparenz für Umgebungslicht von mehr als 50% bis hin zu mehr als 60% herstellen.

Weiterhin ergibt sich durch die Verwendung der leicht verfügbaren Kupferkomplexe als p-Dotierstoff ein erhebliches Kosteneinsparpotential, weil insbesondere die p-dotierten Schichten in aller Regel einen erheblichen Anteil an der Gesamtstapeldicke eines Organik-Schichtstapels eines organischen lichtemittierenden Bauelements ausmachen.

### ZWEITES AUSFÜHRUNGSBEISPIEL EINES ORGANISCHEN LICHTEMITTERENDEN BAUELEMENTS

**Fig.2** zeigt eine schematische Darstellung eines zweiten ersten Ausführungsbeispiels eines organischen lichtemittierenden Bauelements 200. Zusätzlich zu der Ausgestaltung des in Bezug auf **Fig. 1** beschriebenen ersten Ausführungsbeispiels weist das organische lichtemittierende Bauelement 200 ein Substrat 202 auf, auf dem die Elektroden und der organische Schichtstapel aufgebracht sind. Das Substrat 202 ist kein notwendiger Bestandteil des organischen lichtemittierenden Bauelements 200. Es dient der mechanischen Stabilisierung des Schichtstapels. Zugleich kann es Bestandteil einer nicht in den Figuren dargestellten Verkapselung des organischen lichtemittierenden Bauelements 200 sein. Ein Substrat 202 kann ebenso in Zusammenhang mit der ersten oder anderen Ausführungsbeispielen des organischen lichtemittierenden Bauelements 100 vorgesehen sein. Es kann ebenso an der Kathode 104 vorgesehen sein. In diesem FAll spricht man von einer invertierten OLED.

Soweit das Substrat 202 von der Anode 202 bedeckt ist, ist es transparent im Spektralbereich der von der aktiven Schicht 110 emittierten Strahlung. Um eine mechanische Stabilität des organischen lichtemittierenden Bauelements 200 zu erhalten, können Materialien, wie Glas, Saphir oder auch biegsame Folien, wie Plastik verwendet werden. Ebenso können transparente Halbleiterträger, wie SiC, GaN, InN oder ähnliche Materialien verwendet werden. Soweit das Substrat 202 an einer intransparenten Kathode 104 angebracht ist, können verspiegelte Materialien, bspw. Materialien mit einer guten Wärmeleitfähigkeit für das Substrat verwendet werden.

Das organische lichtemittierende Bauelement 200 weist eine transparente Kathode 204 auf, d.h. die Kathode 204 hat einen hohen Transmissionskoeffizienten für aus der aktiven Schicht 110 emittierte Strahlung. Die Kathode 204 kann dazu aus einem ähnlichen Material wie die Anode 102 gebildet sein. Wesentlich ist eine hohen Beweglichkeit von Elektronen in dem Kathodenmaterial und damit eine hohe elektrische Leitfähigkeit. Weiterhin kann die elektronentransportierende Schicht 108 ebenfalls transparent ausgestaltet sein. Dafür geeignete Materialien sind dem Fachmann geläufig. Derart kann ein Anteil der in der aktiven Schicht 110 emittierten Strahlung 206 über die Kathode 104 ausgekoppelt werden. Das organische lichtemittierende Bauelement 200 emittiert damit Strahlung über die Anode 102 und die Kathode 104. Weil die in dem organischen lichtemittierenden Bauelement 200 verwendeten Materialien sämtlich einen hohen Transmissionskoeffizienten aufweisen, erscheint das organische lichtemittierende Bauelement 200 außerhalb eines Betriebs transparent. Man spricht auch von einer transparenten OLED.

Gerade bei der Herstellung einer transparenten OLED ist der beschriebene Kupferkomplex von besonderen Vorteil. Weil die HTL in vielen Architekturen einen erheblichen Anteil an der Schichtdicke des organischen Schichtstapels ausmacht, erweist sich die durch die Verwendung des Kupferkomplexes erreichte hohe Transparenz der Ladungstransportschicht als wesentlich für eine hohe Transparenz der gesamten OLED. Zudem kann der Kupferkomplex auch in anderen p-dotierten Funktionsschichten des organischen lichtemittierenden Bauelements zur Anwendung kommen.

### ABSCHLIESSENDE FESTSTELLUNG

Das organische lichtemittierende Bauelement wurde zur Veranschaulichung des zugrundeliegenden Gedankens anhand einiger Ausführungsbeispiele beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso möglich, in Ausführungsbeispielen einzelne dargestellte Merkmale oder besondere Ausgestaltungen wegzulassen oder hinzuzufügen, soweit die allgemeine technische Lehre realisiert bleibt.

### LITERATUR

In diesem Dokument sind die folgenden Veröffentlichungen zitiert:
[1] DE 101 35 513 A1.
[2] US 2004/086745 A1 (IWAKUMA TOSHIHIRO [JP] ET AL) 6. Mai 2004 (2004-05-06).
[3] YULIA SEVRYUGINA ET AL: "Tetranuclear copper(i) clusters: impact of bridging carboxylate ligands on solid state structure and photoluminescence", Chem. Commun. 2007, 3853-3855..
[4] SEVRYUGINA ET AL: "X-ray structure and photoluminescence of copper(I) 2,6-bis(trifluoromethyl)benzoate", Inorg. Chim. Acta, 2007, 360, 3103-3107.
[5] SHARMA R P ET AL: "Segregated aromatic π-π stacking interactions involving fluorinated and non-fluorinated benzene rings: Cu(py)2 (pfb)2 and Cu(py)2 (pfb)2 (H2 O) (py=pyridine and pfb=pentafluorobenzoate)", J. Fluor. Chem., 2010, 131, 456-460.

**BEZUGSZEICHENLISTE**

| | |
|---|---|
| Organisches lichtemittierendes Bauelement | 100 |
| Anode | 102 |
| Kathode | 104 |
| Stromquelle | 106 |
| Lochtransportierende Schicht | 108 |
| Aktive Schicht | 110 |
| Elektronentransportierenden Schicht | 112 |
| Emittierte Strahlung | 114 |
| Organisches lichtemittierendes Bauelement | 200 |
| Substrat | 202 |
| Transparente Kathode | 204 |
| Emittierte Strahlung | 206 |
| Elektrisches Feld. | **E** |

## Patentansprüche

1. Organisches lichtemittierendes Bauelement (100, 200) mit
- einer aktiven Schicht (110) zur Emission von elektromagnetischer Strahlung;
- einer Anode (102) und
- einer zwischen der aktiven Schicht (110) und der Anode (102) angeordneten organischen Ladungstransportschicht (108) zum Ladungsträgertransport von der Anode (102) in die aktive Schicht (110),
wobei von der aktiven Schicht (110) emittierte elektromagnetische Strahlung (114) über die Anode (102) aus dem organischen lichtemittierenden Bauelement (100, 200) auskoppelbar ist und
wobei die organische Ladungstransportschicht (110) einen Kupferkomplex umfasst, der wenigstens einen Liganden mit der chemischen Struktur gemäß Formel I aufweist: 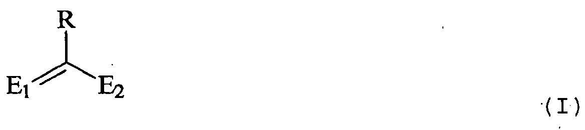 worin E₁ und E₂ jeweils unabhängig voneinander eines der folgenden Elemente sind: Sauerstoff, Schwefel oder Selen, und R ausgewählt ist aus der Gruppe: Wasserstoff oder substituierter oder unsubstituierter, verzweigter, linearer oder zyklischer Kohlenwasserstoffe,
einer Kathode (104) und
einer zwischen der aktiven Schicht (110) und der Kathode (104) angeordneten elektronentransportierenden Schicht (112), wobei die elektronentransportierende Schicht ein n-dotiertes Material aufweist.

2. Organisches lichtemittierendes Bauelement (100, 200) gemäß Patentanspruch 1, wobei der Kupferkomplex ein Kupfer(I)penta-Fluor-Benzoat ist.

3. Organisches lichtemittierendes Bauelement (100, 200) gemäß einem der vorangehenden Patentansprüche, wobei der Kupferkomplex als Dotierstoff in einem Matrixmaterial eingebracht ist.

4. Organisches lichtemittierendes Bauelement (100, 200) gemäß Patentanspruch 3, wobei das Matrixmaterial 1-TNATA (4,4',4" -tris(N-(1-naphthyl)-N-phenyl-amino)Triphenylamin aufweist.

5. Organisches lichtemittierendes Bauelement (100, 200) gemäß einem der Patentansprüche 3 oder 4, wobei die organische Ladungstransportschicht (108) eine Dotierstoffkonzentration von 0,1 bis 50 Gewichtsprozent aufweist.

6. Organisches lichtemittierendes Bauelement (100, 200) gemäß einem der Patentansprüche 3 bis 5, wobei die organische Ladungstransportschicht (108) eine Dotierstoffkonzentration von mehr als 1 Gewichtsprozent, insbesondere von mehr als 10 Gewichtsprozent, aufweist.

7. Organisches lichtemittierendes Bauelement (100, 200) gemäß einem der Patentansprüche 3 bis 6, wobei die organische Ladungstransportschicht (108) eine Dotierstoffkonzentration von mehr als ungefähr 5 Gewichtsprozent aufweist.

8. Organisches lichtemittierendes Bauelement (100, 200) gemäß einem der Patentansprüche 3 bis 7, wobei die Ladungstransportschicht (108) einen Dotierungsgradienten von der Anode (102) hin zu der aktiven Schicht (110) aufweist.

9. Organisches lichtemittierendes Bauelement (100, 200) gemäß Patentanspruch 8, wobei die Dotierung Ladungstransportschicht (108) hin zu der aktiven Schicht (110) abnimmt.

10. Organisches lichtemittierendes Bauelement (100, 200) gemäß einem der vorangehenden Patentansprüche mit einer im Spektralbereich der in der aktiven Schicht (110) emittierten elektromagnetischen Strahlung (114, 204) transparenten Kathode.

11. Verwendung eines Kupferkomplexes in einer Ladungstransportschicht (108) eines optoelektronischen Bauelements (100) mit transparentem Anodenkontakt (102) und einer zwischen einer aktiven Schicht (110) und einer Kathode (104) angeordneten elektronentransportierenden Schicht (112), wobei die elektronentransportierende Schicht ein n-dotiertes Material aufweist, wobei der Kupferkomplex wenigstens einen Liganden mit der chemischen Struktur gemäß Formel I aufweist: 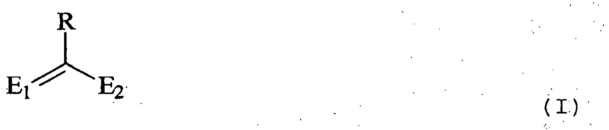 worin E₁ und E₂ jeweils unabhängig voneinander eines der folgenden Elemente sind: Sauerstoff, Schwefel oder Selen, und R ausgewählt ist aus der Gruppe: Wasserstoff oder substituierter oder unsubstituierter, verzweigter, linearer oder zyklischer Kohlenwasserstoffe.

## Claims

1. Organic, light-emitting component (100, 200) having
- an active layer (110) for emission of electromagnetic radiation,
- an anode (102), and
- disposed between the active layer (110) and the anode (102), an organic charge transport layer (108) for charge carrier transport from the anode (102) into the active layer (110),
where electromagnetic radiation (114) emitted from the active layer (110) can be outcoupled from the organic, light-emitting component (100, 200) via the anode (102), and
where the organic charge transport layer (110) comprises a copper complex which has at least one ligand with the chemical structure according to formula I: 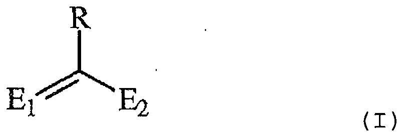 where E₁ and E₂ in each case independently of one another are one of the following elements: oxygen, sulfur, or selenium, and R is selected from the following group: hydrogen or substituted or unsubstituted, branched, linear, or cyclic hydrocarbons,
a cathode (104), and
disposed between the active layer (110) and the cathode (104), an electron-transporting layer (112), the electron-transporting layer comprising an n-doped material.

2. Organic, light-emitting component (100, 200) according to Claim 1, where the copper complex is a copper(I) pentafluorobenzoate.

3. Organic, light-emitting component (100, 200) according to either of the preceding claims, where the copper complex is incorporated as dopant in a matrix material.

4. Organic, light-emitting component (100, 200) according to Claim 3, where the matrix material comprises 1-TNATA {4,4',4"-tris(N-(1-naphthyl)-N-phenylamino)triphenylamine.

5. Organic, light-emitting component (100, 200) according to either of Claims 3 and 4, where the organic charge transport layer (108) has a dopant concentration of 0.1 to 50 weight percent.

6. Organic, light-emitting component (100, 200) according to any of Claims 3 to 5, where the organic charge transport layer (108) has a dopant concentration of more than 1 weight percent, more particularly of more than 10 weight percent.

7. Organic, light-emitting component (100, 200) according to any of Claims 3 to 6, where the organic charge transport layer (108) has a dopant concentration of more than approximately 5 weight percent.

8. Organic, light-emitting component (100, 200) according to any of Claims 3 to 7, where the charge transport layer (108) has a doping gradient from the anode (102) to the active layer (110).

9. Organic, light-emitting component (100, 200) according to Claim 8, where the doping of the charge transport layer (108) decreases toward the active layer (110).

10. Organic, light-emitting component (100, 200) according to any of the preceding claims, having a cathode which is transparent in the spectral range of the electromagnetic radiation (114, 204) emitted in the active layer (110).

11. Use of a copper complex in a charge transport layer (108) of an optoelectronic component (100) with transparent anode contact (102) and with, disposed between an active layer (110) and a cathode (104), an electron-transporting layer (112), the electron-transporting layer comprising an n-doped material, where the copper complex has at least one ligand with the chemical structure according to formula I: 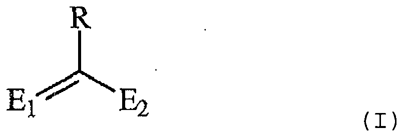 where E₁ and E₂ in each case independently of one another are one of the following elements: oxygen, sulfur, or selenium, and R is selected from the following group: hydrogen or substituted or unsubstituted, branched, linear, or cyclic hydrocarbons.

## Revendications

1. Composant électroluminescent organique (100, 200) comportant
- une couche active (110) pour l'émission d'un rayonnement électromagnétique ;
- une anode (102) et
- une couche de transport de charges organique (108), disposée entre la couche active (110) et l'anode (102), pour le transport de porteurs de charge de l'anode (102) dans la couche active (110),
le rayonnement électromagnétique (114) émis par la couche active (110) pouvant être découplé du composant électroluminescent organique (100, 200) via l'anode (102) et
la couche de transport de charges organique (110) comprenant un complexe de cuivre qui comporte au moins un ligand ayant la structure chimique selon la formule I : 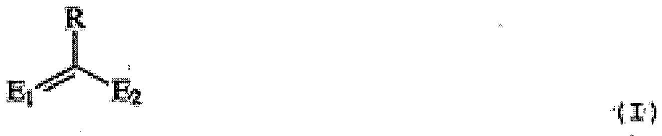 dans laquelle E₁ et E₂ représentent chacun indépendamment l'un de l'autre l'un des éléments suivants : oxygène, soufre ou sélénium,
et R est choisi dans le groupe : hydrogène ou hydrocarbures ramifiés, linéaires ou cycliques, substitués ou non substitués,
une cathode (104) et
une couche de transport d'électrons (112) disposée entre la couche active (110) et la cathode (104), la couche de transport d'électrons comportant un matériau dopé-n.

2. Composant électroluminescent organique (100, 200) selon la revendication 1, dans lequel le complexe de cuivre est un pentafluorobenzoate de cuivre-(I).

3. Composant électroluminescent organique (100, 200) selon l'une quelconque des revendications précédentes, dans lequel le complexe de cuivre est introduit en tant que dopant dans un matériau de matrice.

4. Composant électroluminescent organique (100, 200) selon la revendication 3, dans lequel le matériau de matrice comporte de la 1-TNATA (4,4',4"-tris(N-(1-naphtyl)-N-phénylamino)triphénylamine.

5. Composant électroluminescent organique (100, 200) selon l'une quelconque des revendications 3 et 4, dans lequel la couche de transport de charges organique (108) présente une concentration de dopant de 0,1 à 50 pour cent en poids.

6. Composant électroluminescent organique (100, 200) selon l'une quelconque des revendications 3 à 5, dans lequel la couche de transport de charges organique (108) présente une concentration de dopant de plus de 1 pour cent en poids, en particulier de plus de 10 pour cent en poids.

7. Composant électroluminescent organique (100, 200) selon l'une quelconque des revendications 3 à 6, dans lequel la couche de transport de charges organique (108) présente une concentration de dopant de plus d'environ 5 pour cent en poids.

8. Composant électroluminescent organique (100, 200) selon l'une quelconque des revendications 3 à 7, dans lequel la couche de transport de charges (108) présente un gradient de dopage allant de l'anode (102) à la couche active (110).

9. Composant électroluminescent organique (100, 200) selon la revendication 8, dans lequel le dopage de la couche de transport de charges (108) diminue vers la couche active (110).

10. Composant électroluminescent organique (100, 200) selon l'une quelconque des revendications précédentes, comportant une cathode transparente dans la région spectrale du rayonnement électromagnétique (114, 204) émis dans la couche active (110).

11. Utilisation d'un complexe de cuivre dans une couche de transport de charges (108) d'un composant optoélectronique (100) comportant un contact d'anode transparent (102) et une couche de transport d'électrons (112) disposée entre une couche active (110) et une cathode (104), la couche de transport d'électrons comportant un matériau dopé-n, le complexe de cuivre comportant au moins un ligand ayant la structure chimique selon la formule I : 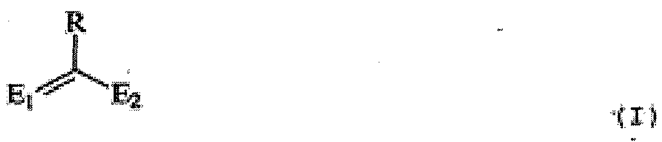 dans laquelle E₁ et E₂ représentent chacun indépendamment l'un de l'autre l'un des éléments suivants : oxygène, soufre ou sélénium,
et R est choisi dans le groupe : hydrogène ou hydrocarbures ramifiés, linéaires ou cycliques, substitués ou non substitués.
